# EUROPÄISCHE PATENTSCHRIFT

(11) **EP 0 965 654 B1**
(45) Veröffentlichungstag und Bekanntmachung des Hinweises auf die Patenterteilung: **19.11.2003**
(21) Anmeldenummer: 99109894.8
(22) Anmeldetag: 19.05.1999
(51) Int. Cl.: C23C 16/06, C23C 16/56, C23C 14/16, C23C 14/58, H01L 21/285, H01L 21/768

(54) **Verfahren zur Erzeugung metallhaltiger Schichten**
Process for manufacturing metal-containing layers
Procédé d'obtention de couches métalliques

(30) Priorität: 20.05.1998 DE 19822749
(43) Veröffentlichungstag der Anmeldung: 22.12.1999
(73) Patentinhaber: Infineon Technologies AG, 81669 München (DE)
(72) Erfinder: Gehring, Oliver, 01069 Dresden (DE); Ruf, Alexander, Dr., 01127 Dresden (DE); Schmidbauer, Sven, 01099 Dresden (DE)
(74) Vertreter: Zimmermann & Partner

(56) Entgegenhaltungen:
- WO-A-95/34092
- US-A- 5 378 660
- US-A- 5 444 018
- US-A- 5 610 099

## Beschreibung

Die vorliegende Erfindung betrifft ein Verfahren zur Erzeugung metallhaltiger Schichten, insbesondere metallhaltiger Diffusionsbarrieren, Kontaktschichten und/oder Antireflex-Schichten, insbesondere für die Anwendung in CMOS-Schaltungen oder DRAM-Speicherbausteinen sowie in sogenannten "embedded DRAM"-Bausteinen.

Integrierte Schaltkreise, insbesondere CMOS-Schaltungen oder DRAM-Speicherbausteine, werden mit einer Vielzahl von Prozeßschritten hergestellt. Die Herstellungskosten dieser Schaltkreise werden dabei durch die Prozeßkomplexität und die physikalische Bearbeitungszeit bestimmt. Hochkomplexe Bausteine erfordern häufig mehrere hundert einzelne Prozeßschritte und eine Vielzahl von Tagen für den Prozessdurchlauf des Produkts.

Ein Teil der Prozeßschritte muß dabei für die Kontaktierung von dotierten Gebieten in dem Halbleitersubstrat oder für die Kontaktierung zweier leitender Schichten aufgewendet werden. Für die Kontaktierung von dotierten Gebieten in dem Halbleitersubstrat werden in modernen DRAM- und Logikgenerationen häufig Kontakte zwischen Silizium und Wolfram verwendet. Es kommen jedoch andere Metalle wie beispielsweise Aluminium zum Einsatz. Zur Vermeidung von unerwünschten Wolfram-Silizium-Reaktionen ("encroachment", "wormholes") bzw. Aluminium-Silizium-Reaktionen ("spiking") werden dabei häufig metallhaltige Schichten, beispielsweise Ti/TiN-Schichten, als Kontakt- bzw. Barriereschichten zwischen Silizium und Wolfram bzw. Silizium und Aluminium eingesetzt.

Auch bei Kontakten zwischen zwei leitenden Schichten werden häufig Ti/TiN- oder TiSi₂-Kontaktschichten eingesetzt. Eine TiN-Schicht über einer Al-Schicht reduziert beispielsweise die natürliche Oxidation der Al-Schicht und führt somit zu niederohmigen Kontakten oder dient als Antireflexschicht. Ebenso ist die Bereitstellung einer TiSi₂-Schicht auf einem Polysiliziumgate eine Maßnahme, um die Leistung von MOS-Transistoren deutlich zu erhöhen.

Wegen der Vielzahl der Anwendungsmöglichkeiten sind Metallschichten, insbesondere Titanschichten, auch der Gegenstand einer Reihe von Untersuchungen. So behandeln beispielsweise die Veröffentlichungen "Nitridation of Polycrystalline Titanium as Studied by in situ Angle-resolved X-ray Photoelectron Spectroscopy", A Ermolieff et al. in "Surface and Interface Analysis" Vol. 11, Seiten 563 - 568 (1988), "Tungsten Contacts for a 256M DRAM Process ising a thermally formed TiN Diffusion Barrier", J. Gambino et al., 1996 VMIC Conference 1996 ISMIC - 106/96/0180i(c), June 18 - 20, und Influence of the sputtering method of TiN/Ti films on the resistance of high aspect ratio contact holes", R. Kanamura et al., 1996 VMIC Conference 1996 ISMIC - 106/96/0554(c), June 18 - 20 Eigenschaften und Anwendungen von titanhaltigen Schichten.

Die genannten Anwendungen setzen jedoch, insbesondere bei kleinen Strukturbreiten, metallhaltige Schichten von guter Qualität voraus, damit die gewünschten Eigenschaften der metallhaltigen Schichten auch erzielt werden können. Dabei gilt es insbesondere Verunreinigungen der metallhaltigen Schicht bzw. die Oxidation des Metalls während des Prozeßablaufs wirksam zu verhindern. Dies kann jedoch bei herkömmlichen Verfahren zur Erzeugung von metallhaltigen Schichten nicht gewährleistet werden, was beispielsweise zu erhöhten Kontaktwiederständen führt.

Es ist daher die Aufgabe der vorliegenden Erfindung, ein Verfahren zur Erzeugung metallhaltiger Schichten, insbesondere metallhaltiger Diffusionsbarrieren, Kontaktschichten und/oder Antireflexschichten bereitzustellen, das die genannten Nachteile des Standes der Technik vermeidet oder mindert. Insbesondere ist es eine Aufgabe der vorliegenden Erfindung, ein Verfahren zur Erzeugung metallhaltiger Schichten bereitzustellen, das eine Oxidation des Metalls während des Verfahrens weitgehend verhindert.

Diese Aufgabe wird von dem Verfahren gemäß Patentanspruch 1 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen.

Erfindungsgemäß wird ein Verfahren zur Erzeugung metallhaltiger Schichten, insbesondere metallhaltiger Diffusionsbarrieren, Kontaktschichten und/oder Antireflexschichten bereitgestellt. Das erfindungsgemäße Verfahren umfaßt die Schritte:
a) Aufbringen einer Metallschicht mit einer vorgegebenen Dikke bei erhöhter Temperatur;
b) Abkühlen der Metallschicht in einer stickstoffhaltigen Atmosphäre, so daß eine Metallnitridschicht gebildet wird.

Der Einsatz einer stickstoffhaltigen Atmosphäre hat zum einen den Vorteil, daß, bedingt durch die im Vergleich zu herkömmlich verwendeten Inertgasen wie Argon schnellere Wärmeabführung, die Abkühlzeit verkürzt ist. Dies hat in der Regel einen deutlich erhöhten Anlagendurchsatz zur Folge, was wiederum positiv auf die Herstellungskosten auswirkt. Durch den Einsatz einer stickstoffhaltigen Atmosphäre läßt sich die Abkühlzeit um rund 40% verringern.

Zum anderen wird durch sich bildenden Metallnitridschicht (Passivierungsschicht) eine sonst unvermeidliche Oxidation der Metallschicht deutlich vermindert. Dies hat zur Folge, daß weniger Sauerstoff in die Metallschicht eingebaut wird, was geringere Kontaktwiderstände und letztlich auch eine geringere Metallschichtdicke ermöglicht. Dies wirkt sich wiederum positiv auf den erzielbaren Durchsatz aus. Die technische Einsatzmöglichkeit beispielsweise von "Ti-Linern" bzw. die Verwendung von Titan für Salizidprozesse kann somit technologisch für weitere Produktgenerationen verlängert werden.

Bevorzugt wird die Metallschicht bei einer Temperatur von mehr als 100°C, insbesondere mehr als 300°C, aufgebracht.

Weiterhin ist es bevorzugt, wenn die Metallschicht auf eine Temperatur von weniger als 100°C abgekühlt wird.

Gemäß einer bevorzugten Ausführungsform wird die Metallschicht durch ein CVD-Verfahren (Chemical Vapor Deposition) oder ein PVD-Verfahren (Physical Vapor Deposition), insbesondere eine Sputtertechnik, aufgebracht.

Weiterhin ist es bevorzugt, wenn als Metall Titan, Tantal, Molybdän oder Wolfram verwendet wird

Bevorzugt wird eine Titanschicht auf eine Siliziumoberfläche aufgebracht.

Dabei ist es insbesondere bevorzugt, wenn die Titanschicht nach dem Abkühlen in einer stickstoff- und wasserstoffhaltigen Atmosphäre einer Wärmebehandlung unterzogen wird, so daß das Titan an der Kontaktfläche zum Silizium zu Titansilizid reagiert.

Die Wärmebehandlung sollte bei einer Temperatur von etwa 500 bis 1000°C, bevorzugt 600 bis 900°C, durchgeführt werden.

Weiterhin ist es für manche Anwendungen bevorzugt, wenn die Titannitridschicht nach Fertigstellung der titanhaltigen Schicht, bevorzugt naßchemisch, entfernt wird.

Darüber hinaus ist es bevorzugt, wenn das Aufbringen der Metallschicht in einer ersten Kammer und das Abkühlen der Metallschicht in einer zweiten Kammer durchgeführt wird, wobei die Halbleiterstruktur nach dem Aufbringen der Metallschicht unter Beibehaltung der Vakuumbedindungen von der ersten Kammer in die zweite Kammer transportiert wird. Auf diese Weise wird eine Nitridierung der Metallquelle für das Aufbringen der Metallschicht wirksam verhindert.

Die Erfindung wird nachfolgend anhand der Figuren der Zeichnungen näher dargestellt. Es zeigen
die Figuren 1a bis 1d eine schematische Darstellung einer ersten Ausführungsform des erfindungsgemäßen Verfahren, und
die Figuren 2a bis 2d eine schematische Darstellung einer zweiten Ausführungsform des erfindungsgemäßen Verfahren.

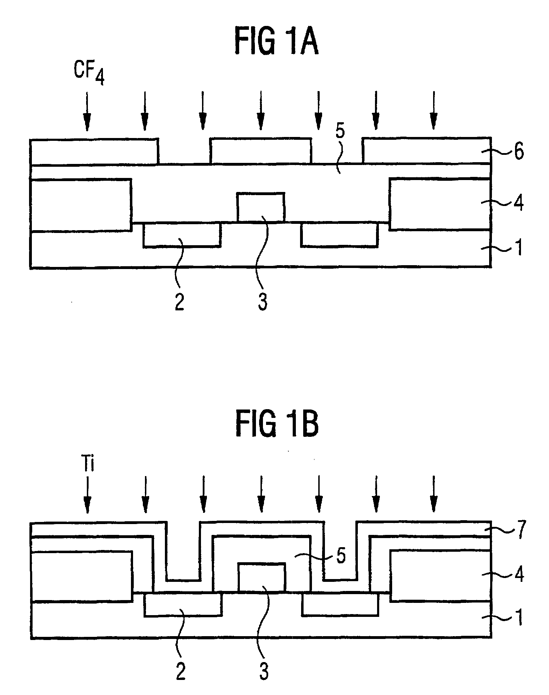

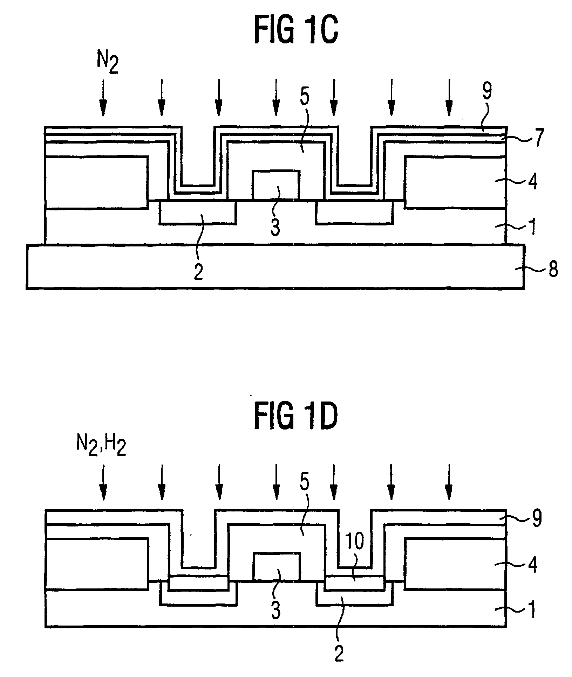

Fig. 1a zeigt eine Halbleiterstruktur, wie sie für die Erzeugung von CMOS-Schaltungen verwendet wird. Auf einer Siliziumscheibe 1 sind n- bzw. p-leitenden Siliziumbereiche 2, ein Gate 3 und eine STI-Isolierung 4 (shallow trench isolation) vorgesehen. Zur Herstellung von Kontakten zwischen noch zu erzeugenden Aluminiumbahnen und den n- bzw. p-leitenden Siliziumbereichen 2 wird zunächst großflächig eine Siliziumoxidschicht 5 beispielsweise mit einem TEOS-Prozeß abgeschieden. Die Siliziumoxidschicht 5 wird nachfolgend durch einen CMP-Schritt (chemisch mechanisches Polieren) planarisiert. Auf das Oxid wird anschließend ein Photolack 6 aufgetragen und lithographisch mit den Kontaktlochgeometrien, justiert zu den Strukturen der Siliziumscheibe 1 strukturiert. Die sich daraus ergebende Situation ist in Figur 1a gezeigt.

Nach der Strukturierung des Photolacks 6 werden die Kontaktlöcher beispielsweise mit CF₄ geätzt und der Photolack sowie anschließend das natürliche Oxid auf dem Silizium am Kontaktlochboden (beispielsweise mit gepufferter Flußsäure) entfernt. Um Adsorbate auf der Scheibenoberfläche zu entfernen, wird die Siliziumscheibe 1 anschließend unter Vakuumbedingungen ausgeheizt. Auf die so vorbereitete Halbleiterstruktur wird nun eine Titanschicht 7 gesputtert (siehe Figur 1b). Je nach eingesetzter Sputtertechnik sollte die Schichtdicke des gesputterten Titans so angepaßt werden, daß auf dem Boden des Kontaktlochs mindestens eine Titanschicht 7 von 10 nm erzeugt wird. Um eine gute Kontaktwiderstandsanpassung zu bekommen, wird die Aufbringen der Titanschicht bei einer Temperatur von etwa 400°C auf der Siliziumscheibe durchgeführt.

Nach dem Aufbringen der Titanschicht 7 wird die Siliziumscheibe unter Beibehaltung der Vakuumbedingungen in eine Kühlkammer transportiert. Die vom Sputtern noch heiße Scheibe wird dort auf einem wassergekühltem Chuck 8 abgelegt und auf Raumtemperatur gekühlt. Das Abkühlen wird dabei durch einen Wärmekontakt zum Chuck 8, die thermische Abstrahlung der Siliziumscheibe und die Wechselwirkung mit dem in der Abkühlkammer vorhandenen stickstoffhaltigem Gas, beispielsweise N₂ oder NH₃, erreicht. Durch den Einsatz von Stickstoff bei beispielsweise 10 Torr läßt sich die Abkühlzeit um rund 40% verkürzen. Weiterhin reagiert das Titan mit dem Stickstoff und es wird eine dünne Titannitridschicht 9 gebildet. Die daraus ergebende Situation ist in Fig. 1c gezeigt.

Nach der Abkühlung und Nitrierung in der Abkühlkammer wird die Siliziumscheibe aus der Sputteranlage entnommen und in einem Ofen in einer Atmosphäre aus Stickstoff und Wasserstoff bei etwa 600°C einige Minuten annealed. Dabei bildet sich an der Kontaktfläche des Titans zum Silizium Titansilizid 10 aus und die Titannitridschicht 9 wird verstärkt, so daß in der Regel kein reines Titan mehr zurückbleibt. Die daraus ergebende Situation ist in Fig. 1d gezeigt.

Anschließend wird zur Füllung der Kontaktlöcher Wolfram beispielsweise mit einem CVD-Verfahren abgeschieden und die CMOS-Schaltung kann in üblicherweise fertiggestellt werden.

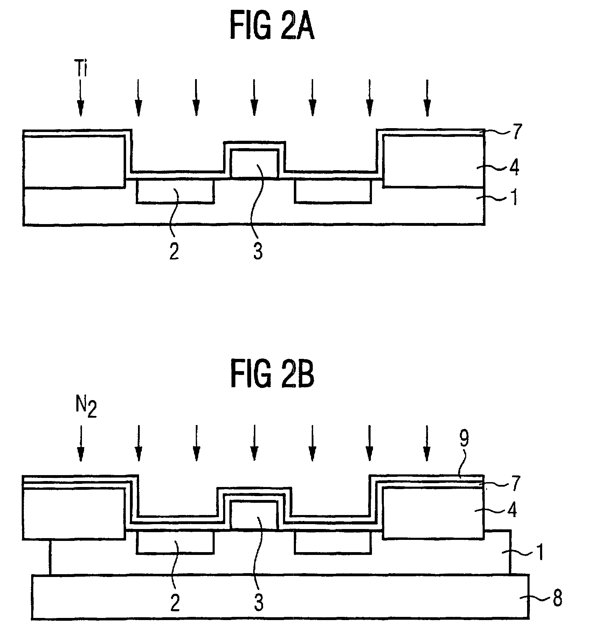

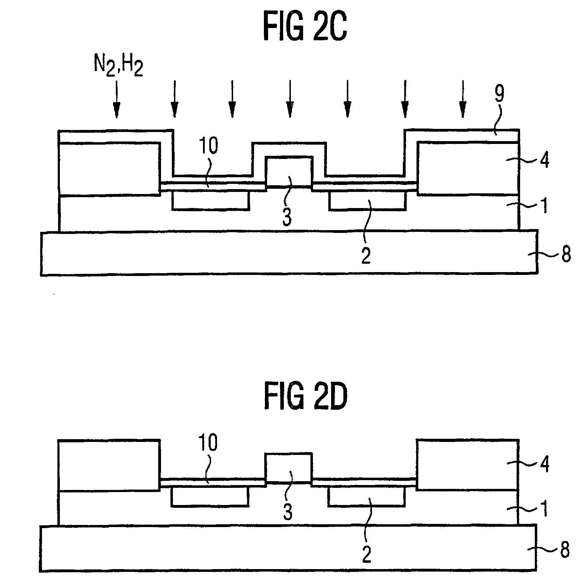

Die Figuren 2a bis 2d zeigen eine schematische Darstellung einer zweiten Ausführungsform des erfindungsgemäßen Verfahren. Fig. 2a zeigt eine Halbleiterstruktur, wie sie für die Erzeugung von CMOS-Schaltungen verwendet wird. Auf einer Siliziumscheibe 1 sind n- bzw. p-leitenden Siliziumbereiche 2, ein Gate 3 und eine STI-Isolierung 4 vorgesehen. Zur Herstellung einer Titansilizidschicht in den späteren Kontaklochbereichen wird zunächst durch eine naßchemische Reinigung (beispielsweise in gepufferte Flußsäure) die natürliche Oxidschicht auf dem Silizium entfernt.

Um Adsorbate auf der Scheibenoberfläche zu entfernen, wird die Siliziumscheibe 1 anschließend unter Vakuumbedingungen bei etwa 350°C ausgeheizt. Auf die so vorbereitete Halbleiterstruktur wird nun eine Titanschicht 7 gesputtert. Die Dikke der erzeugten Titanschicht 7 sollte dabei der angestrebten Titansilizidschichtdicke angepaßt sein.,

Nach dem Aufbringen der Titanschicht 7 wird die Siliziumscheibe unter Vakuumbedingungen in eine Kühlkammer transportiert. Die vom Sputtern noch heiße Scheibe wird dort auf einem wassergekühltem Chuck 8 abgelegt und auf Raumtemperatur gekühlt. Das Abkühlen wird dabei durch einen Wärmekontakt zum Chuck 8, die thermische Abstrahlung der Siliziumscheibe und die Wechselwirkung mit dem in der Abkühlkammer vorhandenen stickstoffhaltigem Gas, beispielsweise N₂ oder NH₃, erreicht. Durch den Einsatz von Stickstoff bei beispielsweise 10 Torr läßt sich die Abkühlzeit um rund 40% verkürzen. Weiterhin reagiert das Titan mit dem Stickstoff und es wird eine dünne Titannitridschicht 9 gebildet. Die daraus ergebende Situation ist in Fig. 2b gezeigt.

Die abgekühlte Scheibe wird nun aus der Sputteranlage entnommen und zur Salizierung in einen Ofen mit einer stickstoffund wasserstoffhaltigen Atmosphäre gegeben. Bei einer Temperatur von etwa 900°C reagiert das Titan an der Kontaktfläche des Titans zum Silizium zu Titansilizid 10. Weiterhin wird die Titannitridschicht 9 verstärkt, so daß in der Regel kein reines Titan mehr zurückbleibt. Die daraus ergebende Situation ist in Fig. 2c gezeigt.

Nach diesem Annealschritt wird das Titannitrid naßchemisch beispielsweise mit einer amoniak- und wasserstoffperoxidhaltigen Säure entfernt, so daß an den Siliziumoberflächen Titansilizid 10 zurückbleibt.

## Patentansprüche

1. Verfahren zur Erzeugung metallhaltiger Schichten, insbesondere metallhaltiger Diffusionsbarrieren, Kontaktschichten und/oder Antireflexschichten, auf einer Halbleiterstruktur mit den Schritten:
a) Aufbringen einer Metallschicht mit einer vorgegebenen Dikke bei erhöhter Temperatur;
b) Abkühlen der Metallschicht in einer stickstoffhaltigen Atmosphäre, so daß eine Metallnitridschicht gebildet wird.

2. Verfahren nach Anspruch 1, **dadurch gekennzeichnet, daß** die Metallschicht bei einer Temperatur von mehr als 100°C, insbesondere mehr als 300°C, aufgebracht wird.

3. Verfahren nach Anspruch 1 oder 2, **dadurch gekennzeichnet, daß** die Metallschicht auf eine Temperatur von weniger als 100°C abgekühlt wird.

4. Verfahren nach einem der vorstehenden Ansprüche, **dadurch gekennzeichnet, daß** die Metallschicht durch ein CVD-Verfahren oder ein PVD-Verfahren, insbesondere eine Sputtertechnik, aufgebracht wird.

5. Verfahren nach einem der vorstehenden Ansprüche, **dadurch gekennzeichnet, daß** als Metall Titan, Tantal, Molybdän oder Wolfram verwendet wird.

6. Verfahren nach einem der vorstehenden Ansprüche, **dadurch gekennzeichnet, daß** eine Titanschicht auf eine Siliziumoberfläche aufgebracht wird.

7. Verfahren nach Anspruch 6, **dadurch gekennzeichnet, daß** die Titanschicht nach dem Abkühlen in einer stickstoff- und wasserstoffhaltigen Atmosphäre einer Wärmebehandlung unterzogen wird, so daß das Titan an der Kontaktfläche zum Silizium zu Titansilizid reagiert.

8. Verfahren nach Anspruch 7, **dadurch gekennzeichnet, daß** die Wärmebehandlung bei einer Temperatur von etwa 500 bis 1000°C, bevorzugt 600 bis 900°C, durchgeführt wird.

9. Verfahren nach einem der vorstehenden Ansprüche, **dadurch gekennzeichnet, daß** die Metallnitridschicht, bevorzugt naßchemisch, entfernt wird.

10. Verfahren nach einem der vorstehenden Ansprüche, **dadurch gekennzeichnet, daß** das Aufbringen der Metallschicht in einer ersten Kammer und das Abkühlen der Metallschicht in einer zweiten Kammer durchgeführt wird, wobei die Halbleiterstruktur nach dem Aufbringen der Metallschicht unter Beibehaltung der Vakuumbedindungen von der ersten Kammer in die zweite Kammer transportiert wird.

## Claims

1. Process for producing metal-containing layers, in particular metal-containing diffusion barriers, contact layers and/or antireflection layers, on a semiconductor structure, having the following steps:
a) Application of a metal layer having a predetermined thickness at an elevated temperature;
b) Cooling of the metal layer in a nitrogen-containing atmosphere, a metal nitride layer thereby being formed.

2. Process according to Claim 1, **characterized in that** the metal layer is applied at a temperature of more than 100°C, in particular more than 300°C.

3. Process according to Claim 1 or 2, **characterized in that** the metal layer is cooled to a temperature of less than 100°C.

4. Process according to one of the preceding claims, **characterized in that** the metal layer is applied by means of a CVD process or a PVD process, in particular a sputtering technique.

5. Process according to one of the preceding claims, **characterized in that** the metal used is titanium, tantalum, molybdenum or tungsten.

6. Process according to one of the preceding claims, **characterized in that** a titanium layer is applied to a silicon surface.

7. Process according to Claim 6, **characterized in that** the titanium layer is subjected to a heat treatment after cooling in a nitrogen- and hydrogen-containing atmosphere, with the result that the titanium reacts to form titanium silicide at the area of contact with the silicon.

8. The process claimed in Claim 7, **characterized in that** the heat treatment is carried out at a temperature of about 500 to 1000°C, preferably 600 to 900°C.

9. Process according to one of the preceding claims, **characterized in that** the metal nitride layer is removed, preferably by wet-chemical means.

10. Process according to one of the preceding claims, **characterized in that** the application of the metal layer is carried out in a first chamber and the cooling of the metal layer is carried out in a second chamber, the semiconductor structure being transported from the first chamber into the second chamber after the application of the metal layer, with the vacuum conditions being maintained.

## Revendications

1. Procédé pour produire des couches à teneur en métal, notamment des barrières de diffusion, des couches de contact et/ou des couches antireflets à teneur en métal, sur une structure de semi-conducteur comportant les étapes :
a) on dépose une couche métallique ayant une épaisseur prescrite à une température augmentée ;
b) on refroidit la couche métallique dans une atmosphère à teneur en azote, si bien qu'il se forme une couche de nitrure métallique.

2. Procédé suivant la revendication 1, **caractérisé en ce que** l'on dépose la couche métallique à une température de plus de 100°C, notamment de plus de 300°C.

3. Procédé suivant la revendication 1 ou 2, **caractérisé en ce que** l'on refroidit la couche métallique à une température de moins de 100°C.

4. Procédé suivant l'une des revendications précédentes, **caractérisé en ce que** l'on dépose la couche métallique par un procédé CVD ou un procédé PVD, notamment par une technique de pulvérisation cathodique.

5. Procédé suivant l'une des revendications précédentes, **caractérisé en ce que** l'on utilise comme métal du titane, du tantale, du molybdène ou du tungstène.

6. Procédé suivant l'une des revendications précédentes, **caractérisé en ce que** l'on dépose une couche de titane sur une surface de silicium.

7. Procédé suivant la revendication 6, **caractérisé en ce que** l'on soumet la couche de titane à un traitement thermique après le refroidissement dans une atmosphère à teneur en azote et en hydrogène, si bien que le titane réagit sur la surface de contact avec le silicium pour former une siliciure de titane.

8. Procédé suivant la revendication 7, **caractérisé en ce que** l'on effectue le traitement thermique à une température d'environ 500 à 1 000°C, de préférence de 600 à 900°C.

9. Procédé suivant l'une des revendications précédentes, **caractérisé en ce que** l'on enlève la couche de nitrure métallique de préférence de manière chimique par voie humide.

10. Procédé suivant l'une des revendications précédentes, **caractérisé en ce que** l'on effectue le dépôt de la couche métallique dans une première chambre et le refroidissement de la couche métallique dans une seconde chambre, la structure de semi-conducteur étant transportée, après le dépôt de la couche métallique, en conservant les conditions du vide, de la première chambre à la seconde chambre.
